# EUROPEAN PATENT SPECIFICATION

(11) **EP 4 109 503 B1**
(45) Date of publication and mention of the grant of the patent: **14.02.2024**
(21) Application number: 22164186.3
(22) Date of filing: 24.03.2022
(51) Int. Cl.: H01L 21/768, H01L 23/485, H01L 23/522

(54) **INVERSE TAPER VIA TO SELF-ALIGNED GATE CONTACT**
VIA MIT INVERSER VERJÜNGUNG AUF SELBSTJUSTIERTEM GATE-KONTAKT
INTERCONNEXION VERTICALE À SECTION CONIQUE INVERSÉ SUR CONTACT À GRILLE AUTO-ALIGNÉ

(30) Priority: 24.06.2021 US 202117357936
(43) Date of publication of application: 28.12.2022
(73) Proprietor: INTEL Corporation, Santa Clara, CA 95054 (US)
(72) Inventor: WEI, Andy Chih-Hung, Yamhill, OR 97148 (US)
(74) Representative: HGF

(56) References cited:
- US-A1- 2013 119 474
- US-A1- 2015 076 708
- US-A1- 2019 214 298

## Description

### FIELD

Embodiments of the present disclosure generally relate to the field of integrated circuit (IC) manufacturing, and in particular to gate structure contacts.

### BACKGROUND

Continued growth in computing devices, virtual machines and cloud computing will continue to increase the demand for increased density of transistors in an IC.

Relevant prior art with regard to contact formation can be found in US 2015/076708 A1, US 2019/214298 A1, or US 2013/119474 A1.

### BRIEF DESCRIPTION OF THE DRAWINGS

FIG. 1 illustrates a cross-section of an integrated circuit (IC) structure perpendicular to a gate that shows a via gate contact (VCG) that has two separate sections, in accordance with various embodiments.
FIG. 2 illustrates a legacy implementation of a VCG and a via trench contact (VCT).
FIG. 3 illustrates a cross-section of an IC structure parallel to a gate that shows the VCG with two separate sections, in accordance with various embodiments.
FIG. 4 illustrates a top down view of an IC structure that shows a VCG that has two separate sections near a gate cut, in accordance with various embodiments.
FIGs. 5A-5N illustrates stages in the manufacture of an IC structure with a VCG with two separate sections, in accordance with various embodiments.
FIGs. 6A-6B illustrate two cross-sections of an integrated circuit (IC) structure with a via between two metal lines, in accordance with various embodiments.
FIG. 7 illustrates an example process for manufacturing a IC structure with a VCG that has two separate sections, in accordance with various embodiments.
FIG. 8 illustrates a computing device 800 in accordance with one implementation of the invention.
FIG. 9 illustrates an interposer 900 that includes one or more embodiments of the invention.

### DETAILED DESCRIPTION

Embodiments described herein may be related to apparatuses, processes, and techniques used to construct via gate contact (VCG) between a metal gate of a gate structure and a metallization layer, which may be referred to as M0. In embodiments, the VCG is split into two separate portions. The bottom portion, VCG, may be oversized with respect to the metal gate and may be self-aligned to a trench connector that is in a same layer as the bottom portion of the VCG. The top portion, which may be referred to as VCx, may be an inverse taper that may be used to electrically couple the bottom portion VCG, or electrically couple another trench contact, with the metallization layer.

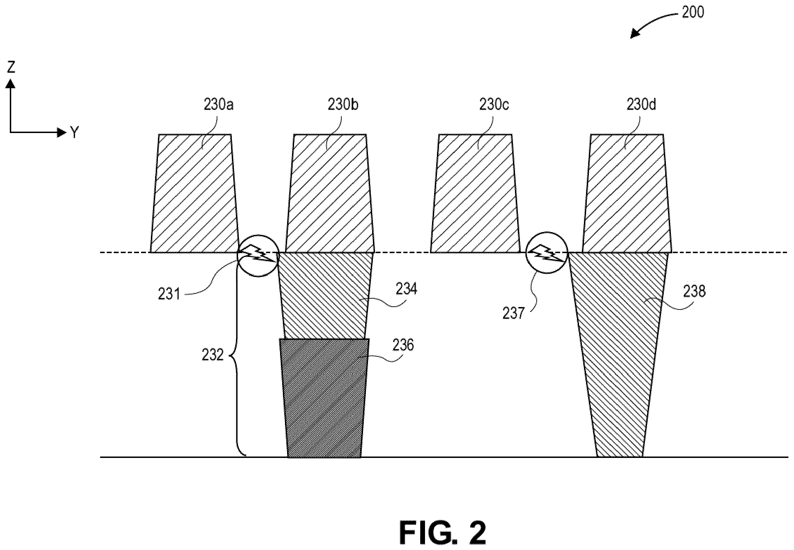

Legacy implementations, as discussed further below with respect to FIG. 2, have a low process margin which can result in higher rates of via short and/or open failures when increasing transistor density is attempted. In particular, a VCG that is constructed using legacy techniques, such as two stacked vias or as a single via, requires a greater distance between the M0 layers because of the increasing widening from the base of the VCG to the top of the VCG where it electrically couples with the M0 layer. This increases the possibility of shorting.

In particular with legacy implementations, as the M0 pitch scales down, it becomes more difficult to align a VCG and a via trench contact (VCT) to the M0. This problem is particularly difficult with a subtractive M0, where there is no higher-k dielectric to prevent time-dependent dielectric breakdown. A concurrent issue in legacy implementations is that in standard cells, the M0-to-VCG-to-gate connections becomes very tight, often leaving zero to negative VCG-to-gate enclosure which results in high risk of a contact open.

A result of embodiments described herein that provide the bottom VCG with a large area, and the top VCx with a small top area allows standard cells to be scaled further by (1) fully contacting the gate, and (2) by increasing the margin in the contact with M0 to allow for edge placement error (EPE) during manufacturing. In particular, when M0 itself has an inverse taper due to subtractive metal formation during manufacture. This will allow for improved quality and increased density of transistors on an IC. In addition, embodiments of processes described herein allow the VCG to self-align to the gate contact during manufacture.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

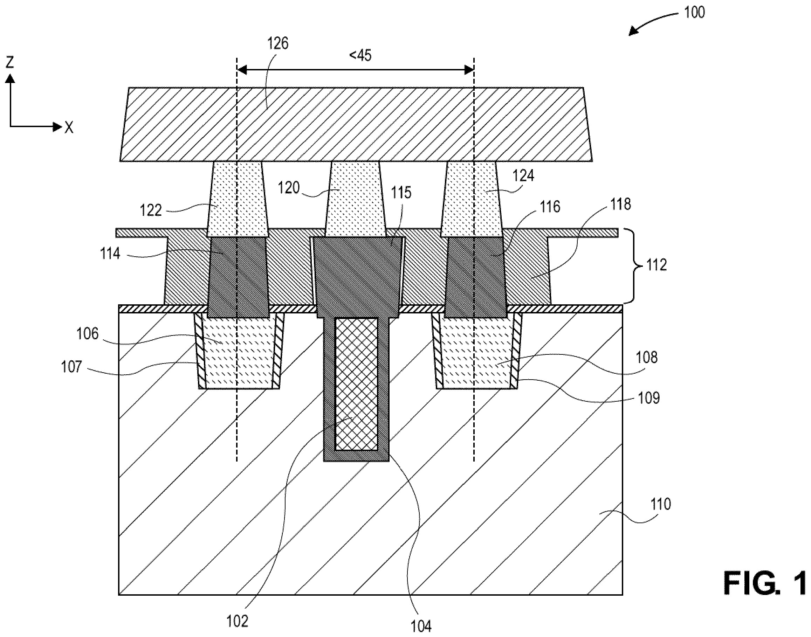

FIG. 1 illustrates a cross-section of an integrated circuit (IC) structure perpendicular to a gate that shows a via gate contact (VCG) that has two separate sections, in accordance with the invention. IC structure 100 includes a cross-section of a portion of a transistor that includes a gate 102 that is surrounded by a gate dielectric 104. Trench connectors 106, 108, may include spacers 107, 109 respectively surrounding the trench connectors 106, 108. The gate 102 and trench connectors 106, 108 may be within a FinFET or Nanoribbon structure 110.

Within layer 112 there is a VCG 115 that is electrically and physically coupled to the gate 102. Layer 112 may also include trench connectors 114, 116 that may be electrically and physically coupled, respectively, with trench connector 106, 108. In embodiments, layer 112 may include a dielectric 118, which may serve as a spacer for VCG 115 self-alignment during manufacture. In embodiments, the trench connectors 114, 116 may have an inverse taper from the bottom of the trench connectors 114, 116 where they connect, respectively with trench connectors 106, 108, to a top of the trench connectors 114, 116. In other embodiments, the trench connectors 114, 116 may have no taper, or an outward taper.

The VCG 115 has an outward taper from the VCG 115 bottom where it couples with the gate 102, to the top of the VCG 115. The VCx 120 may be coupled with the metal 0 layer (M0) 126. At either side of the VCx there may be an inverse taper trench connector 122, 124. In embodiments, a bottom of the trench connector 122, 124, where it couples, respectively, with the top of the trench connector 114, 116 tapers inward to the top of the trench connector 122, 124, where it couples with the M0 126.

In embodiments, the dielectric 118 within layer 112 may have various cavities formed into which the trench connectors 114, 116 and the VCG 115 may be formed. A geometry of the various cavities will produce respective geometries (e.g. tapers) in the trench connectors 114, 116 and the VCG 115. These various cavities within the dielectric 118 may be used to self-align the VCG 115 with the trench connectors 114, 116, as well as with the gate 102.

FIG. 2 illustrates a legacy implementation of a VCG and a via trench contact (VCT). Legacy integrated circuit structure 200 includes a legacy implementation of legacy electrical contact structures 232, 238, respectively, with a M0 230b, 230d. In legacy implementations, the electrical contact structure 232 may come into contact with a trench contact below (not shown), and also be in electrical contact with M0 230b. During legacy manufacture techniques, the legacy electrical contact structure 232 may include two via structures, a trench connector 236 and a VCT 234 placed on top of the trench connector 236. As shown, each of these were created using a traditional via structure, having an outward taper from the bottom of the via 234, 236, to the top.

Because of the upward taper, this legacy implementation may result in the top of the VCT 234 being very close to the M0 230a, possibly causing a short, as shown in region 231, resulting in electrical contact between the VCT 234 and the M0 230a. This is particularly true given the edge placement error (EPE) during manufacture, particularly with respect to manufacturing integrated circuits with a higher density of transistors.

In legacy implementations, the VCG 238 may be a single via with a traditional via structure, having an outward taper from the bottom of the VCG 238 via to the top. In this implementation, because of the height of the via, the top of the VCG 238 may be very broad due to its high aspect ratio, and be very close to the M0 230c, possibly causing a short, as shown in region 237. Again, this is particularly true given EPE during manufacture, particularly with respect to manufacturing integrated circuits with a higher density of transistors.

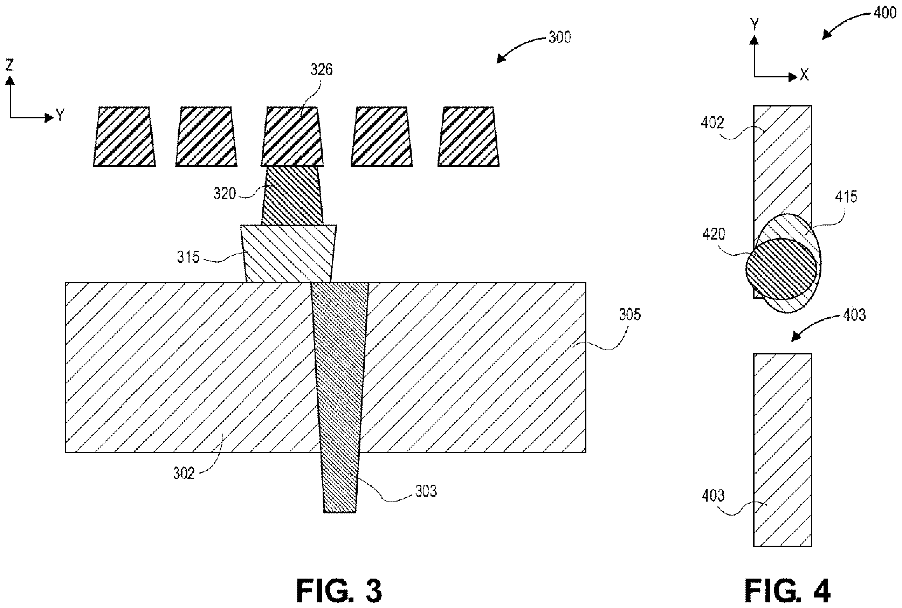

FIG. 3 illustrates a cross-section of an IC structure parallel to a gate that shows the VCG with two separate sections, in accordance with various embodiments. IC structure 300, which may be similar to IC structure 100, includes a cross-section of a portion of a transistor that includes a gate 302, VCG 315, a VCx 320, and a M0 326, which may be similar to gate 102, VCG 115, VCX 120, and M0 126 of FIG. 1.

As shown, a top portion of the VCG 315 is coupled with a bottom portion of the VCx 320, where a bottom of the VCG 315 that is coupled with the gate 302 may have a larger surface area than a bottom of the VCX 320 that is coupled with the top of the VCG 315. The sides of the VCG 315 tapers outward from the bottom to the top. In this way, the bottom of the VCG 315 provides a good electrical connection with the gate 302, and even permits a partial overlap with a gate cut 303, that may be used to electrically and physically decouple portions of the gate 302, 305.

FIG. 4 illustrates a top down view of an IC structure that shows a VCG that has two separate sections near a gate cut, in accordance with various embodiments. IC structure 400, which may be similar to IC structure 300 of FIG. 3, shows a top-down view with the M0 326 not shown for clarity. VCG 415 is electrically physically coupled to the top of gate 402, with the VCx 420 electrically and physically coupled to the top of the VCG 415.

In embodiments, the VCG 415 may be elongated parallel to the gate 402 to maximize contact area with the gate 402. In embodiments, the elongation of the VCG 415 may overlap in part with a gate cut 403, which may be similar to gate cut 303 of FIG. 3. In this way, even if there is gate cut 403 overlap, the electrical connection between the VCG 415 and the gate 402 will be a robust connection. VCx 420, which may be physically and electrically coupled to the top of the VCG 415 may have a smaller top, to create an electrical connection with the M0 326 that may not overlap with a surface of the M0 326, therefore creating a robust connection that is more tolerant of EPE with the M0 326 during manufacture.

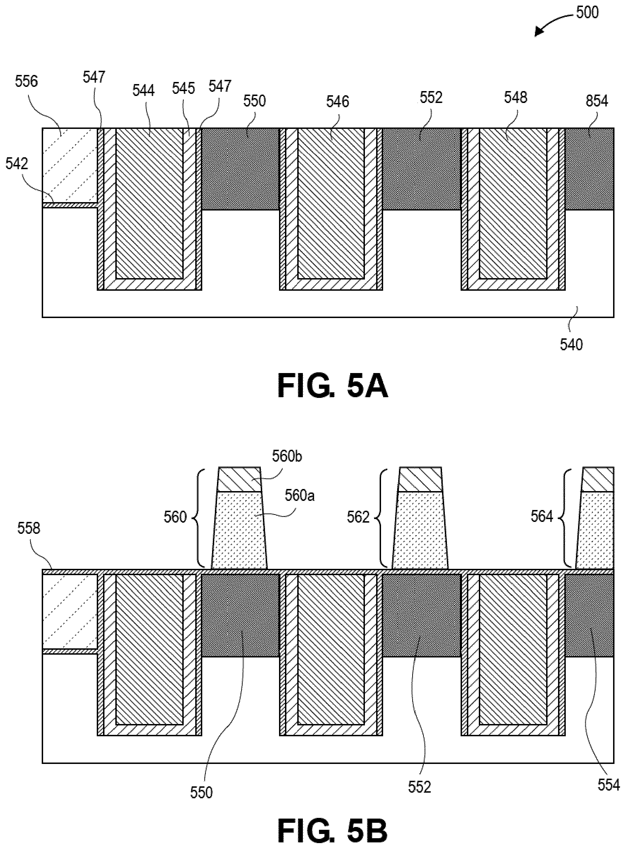

FIGs. 5A-5N illustrates stages in the manufacture of an IC structure with a VCG with two separate sections, in accordance with various embodiments. These various stages of manufacture may be used to construct one or more of the features described with respect to FIGs. 1 and 3-4.

FIG. 5A shows an initial layer onto which the VCG 315 and the VCx 320 are to be subsequently built. The layer includes a FinFET 540, which may be similar to FinFET 110 of FIG. 1, which may include a contact etch stop layer (CESL) 542, with one or more replacement metal gates (RMG) 544, 546, 548. In embodiments, the RMG 544, 546, 548 may be surrounded by a gate dielectric 545 and a gate spacer 547. Between the RMG 544, 546, 548 includes one or more trench connectors 550, 552, 554 that may be electrically and physically coupled with the FinFET 540. In addition, a pre-metal dielectric (PMD) 556 may be disposed on top of the CESL 542 and/or FinFET 540.

FIG. 5B shows the structure of FIG. 5A, with an etch stop layer (ESL) 558 deposited on top of the PMD 556, the RMG 544, 546, 548, and trench connectors 550, 552, 554. Subsequent to the deposition of the etch stop layer 558, sacrificial materials are deposited and patterned as pillars 560, 562, 564, in order to get opposite slope of the portions of connectors between the gate 102 and the M0 126 of FIG. 1. In embodiments, a pillar 560 may include an amorphous silicon (a-Si), component 560a and a silicon nitride component 560b. Note that the sacrificial pillars 560, 562, 564 are structured with an inward taper from a bottom of the pillar where they couple with the ESL 558 above the trench connectors 550, 552, 554, toward the top of the pillar.

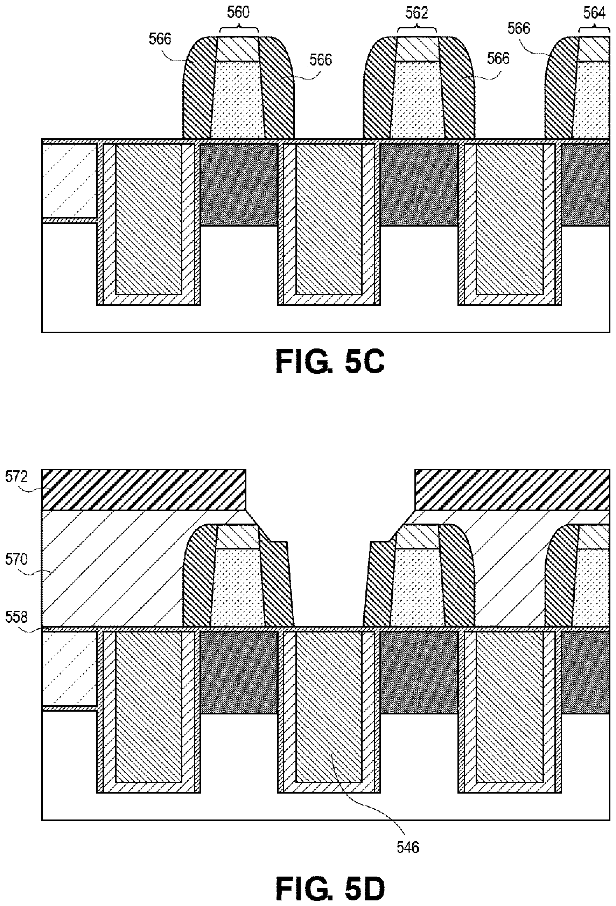

FIG. 5C shows the structure of FIG. 5B, where a layer of silicon nitride 566 is placed around the sides of the pillars 560, 562, 564.

FIG. 5D shows the structure of FIG. 5C, where a flowable dielectric 570 is deposited over the pillars 560, 562, 564, and subsequently planarized. A CHM layer 572 may then be deposited over the planar surface, and a self-aligned VCG may be etched selectively to the ESL 558 over the RMG 546. In embodiments, the etch may be selective to silicon nitride.

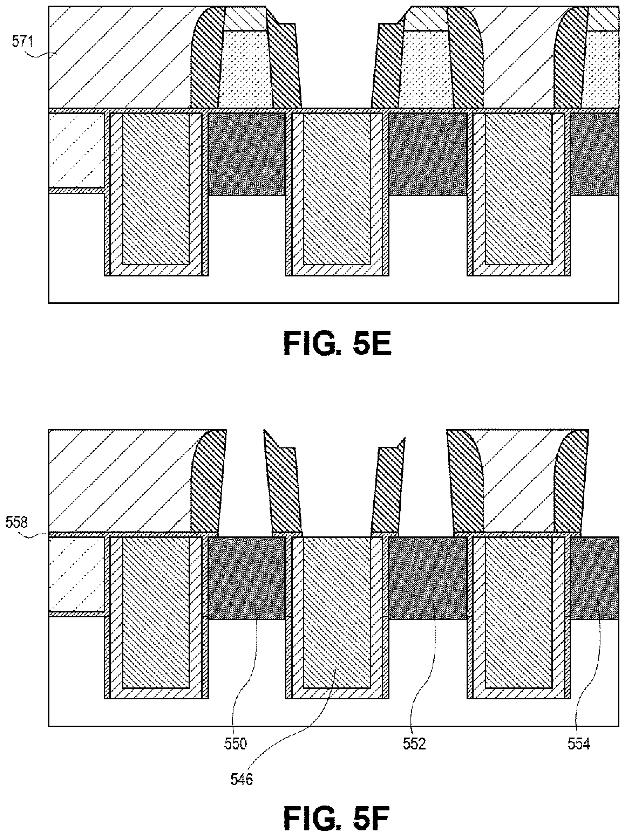

FIG. 5E shows the structure of FIG. 5D, where the CHN layer 572 and a portion of the flowable dielectric 570 has been removed to leave flowable dielectric 571. In embodiments, this removal may be performed by using an oxide etchback.

FIG. 5F shows the structure of FIG. 5E, but with removal of pillars 560, 562, 564, as well as removal of the ESL 558 layer above the trench connector 550, trench connector 552, and trench connector 554, as well as the ESL 558 layer above RMG 546.

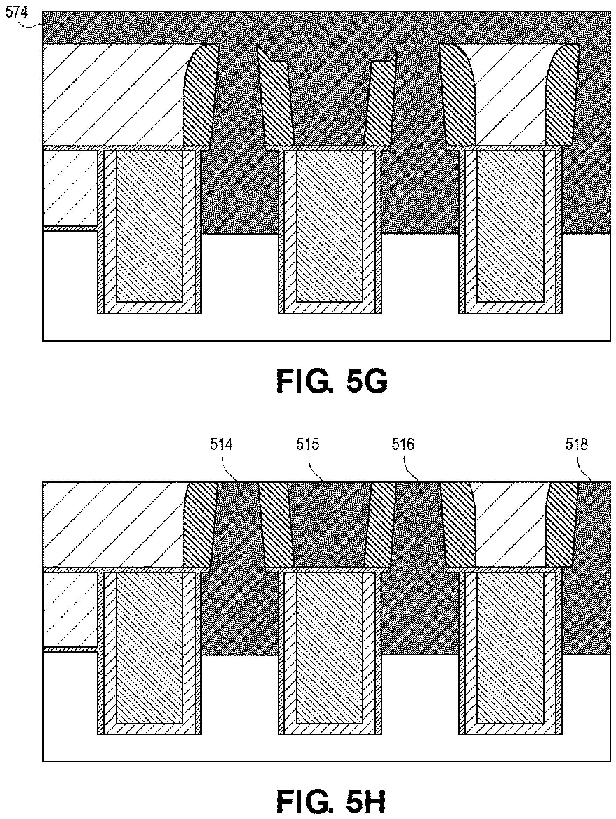

FIG. 5G shows the structure of FIG. 5F, with the metallization layer 574 applied.

FIG. 5H shows the structure of FIG. 5G, with the surface planarized, exposing trench connectors 514, 516, 518, which may be similar to trench connectors 114, 116 of FIG. 1, and exposing a VCG 515, which may be similar to VCG 115 of FIG. 1, VCG 315 of FIG. 3, or VCG 415 of FIG. 4.

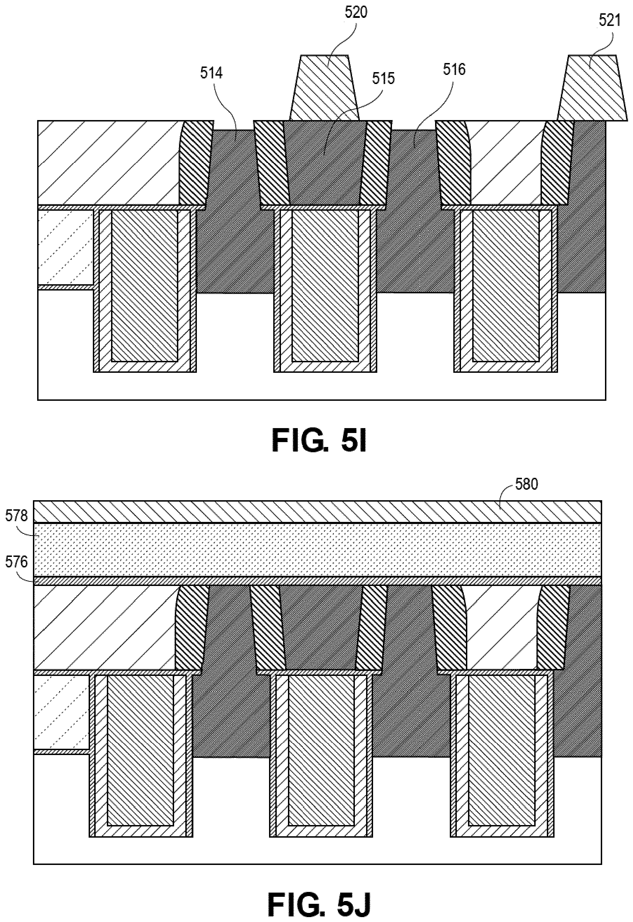

FIG. 5I shows the structure of FIG. 5H, with VCx 520 formed on top of the VCG 515, and a VCx 521 formed on top of another trench connector. In embodiments, the VCG 515, 521 may be formed by metal deposition and a subtractive etch, or it may be formed using a replacement via technique. In embodiments, the subtractive etch may cause an over-etch of the exposed trench channel 514, 516, or of any exposed VCG 515.

FIG. 5J shows the structure of FIG. 5H, and includes techniques for creating a VCx pillar using stack deposition techniques. This technique may be preferred for multi-via mask patterning, given the limitations of subtractively etching multiple times. In embodiments, a pattern is first collected as holes within a collection layer, and then tone inverted. This toning inversion allows a replacement contact via process with a few additional steps. A second layer of ESL layer 576 may be deposited, and subsequently an a-Si 578 layer is deposited on the ESL layer 576. A silicon nitride layer 580 is deposited on the a-Si 578 layer.

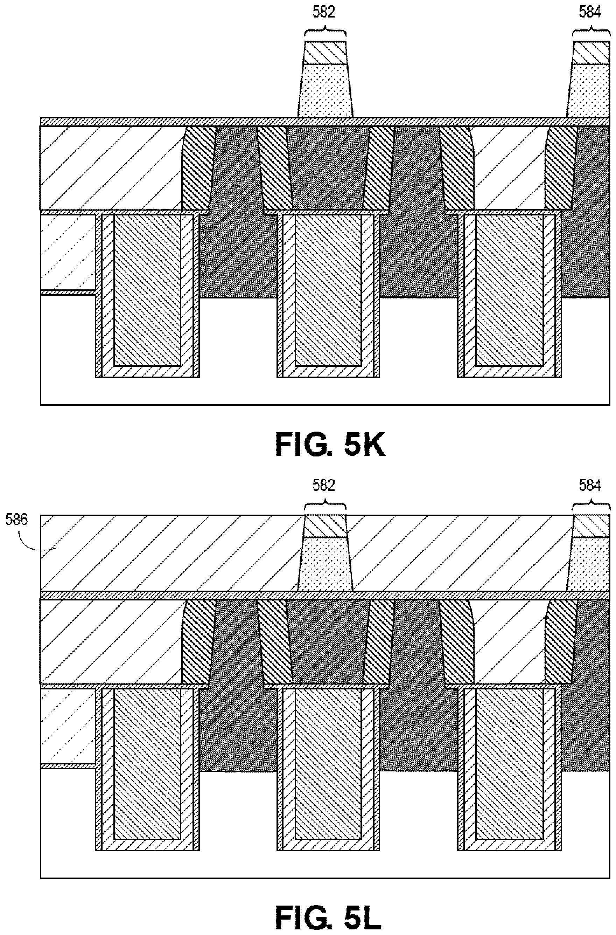

FIG. 5K shows the structure of FIG. 5J, with part of the a-Si layer 578 and silicon nitride layer 580 etched away to leave two pillars 582, 584.

FIG. 5L shows the structure of FIG. 5K, with a PMD layer 586 placed on top of the structure and a CMP process applied to polish the PMD layer 586 to the top surfaces of the pillars 582, 584.

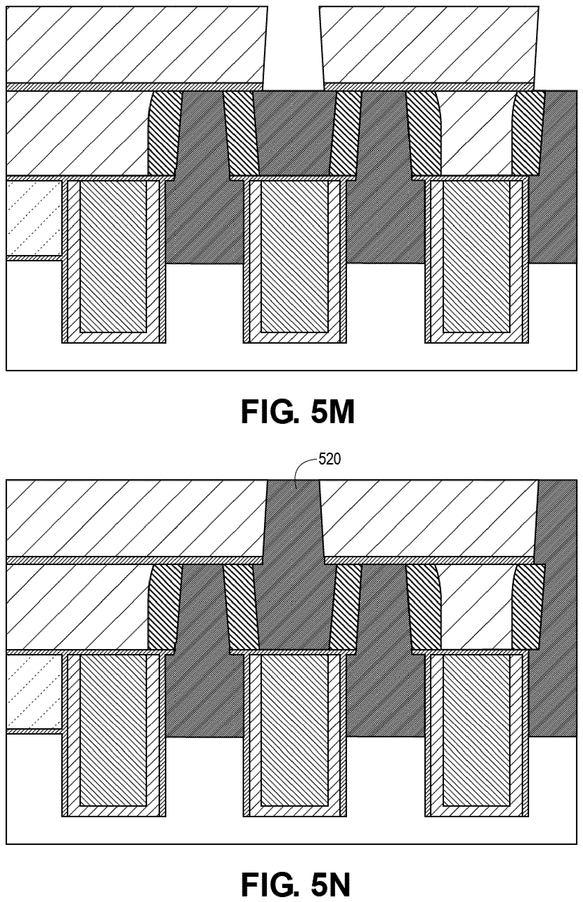

FIG. 5M shows the structure of FIG. 5L, with pillars 582, 584 removed, as well as portions of the ESL 576 at the bottom of pillars 582, 584 removed as well.

FIG. 5N shows the structure of FIG. 5M, with a metallization layer applied and subsequently polished to provide VCx 520, which may be similar to VCx 120 of FIG. 1, VCx 320 of FIG. 3, and VCx 420 of FIG. 4.

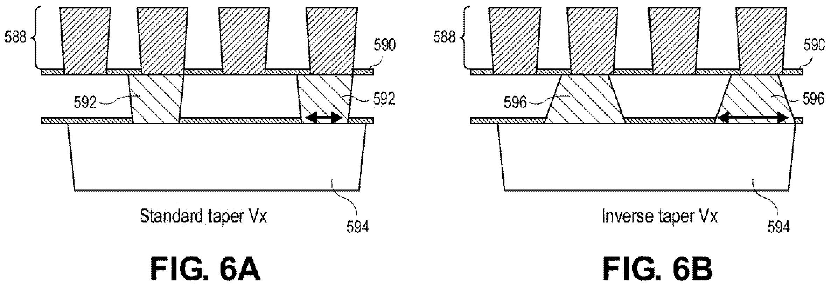

FIGs. 6A-6B illustrate two cross-sections of an integrated circuit (IC) structure with a via between two metal lines, in accordance with various embodiments.

FIG. 6A shows a single damascene metal line 688, which may also be referred to as a Mx+1 line, above an ESL 690 that is coupled with multiple Vx vias 692 that are in turn coupled with another metal layer 694, which may be referred to as Mx. In embodiments, Vx vias 692 may be constructed with techniques described herein, wherein the sides of the Vx vias 692 taper outward from a bottom of the Vx vias 692 to the top of the Vx vias 692.

FIG. 6B shows an alternative embodiment, with a single damascene metal line 688, which may also be referred to as a Mx+1 line, above an ESL 690 that is coupled with multiple Vx vias 696 that are in turn coupled with another metal layer 694, which may be referred to as Mx. In embodiments, the Vx vias 696 may be constructed with techniques described herein, wherein the sides of the Vx vias 696 taper inward from a bottom of the Vx vias 696 to the top of the Vx vias 696.

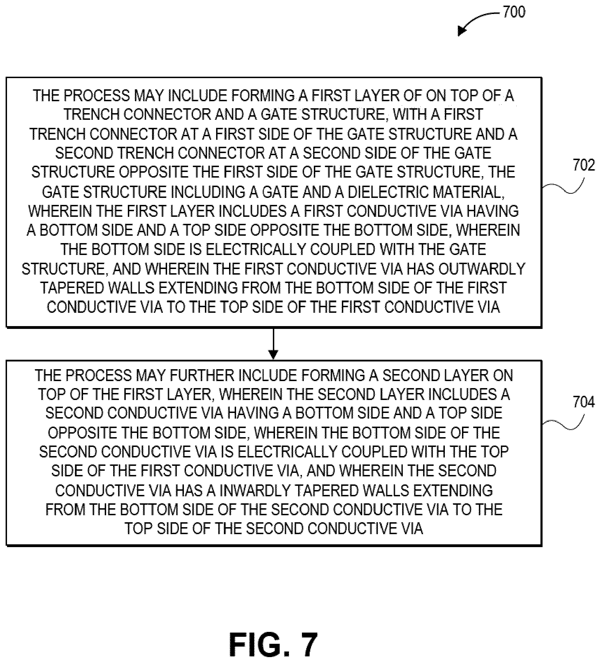

FIG. 7 illustrates an example process for manufacturing an IC structure with a VCG that has two separate sections, in accordance with various embodiments. In embodiments, process 700 may be implemented using the processes, techniques, systems, and apparatus described herein with respect to FIGs. 1 and 3-6B.

At block 702, the process may include forming a first layer of on top of a trench connector and a gate structure, with a first trench connector at a first side of the gate structure and a second trench connector at a second side of the gate structure opposite the first side of the gate structure, the gate structure including a gate and a dielectric material, wherein the first layer includes a first conductive via having a bottom side and a top side opposite the bottom side, wherein the bottom side is electrically coupled with the gate structure, and wherein the first conductive via has outwardly tapered walls extending from the bottom side of the first conductive via to the top side of the first conductive via.

At block 704, the process may further include forming a second layer on top of the first layer, wherein the second layer includes a second conductive via having a bottom side and a top side opposite the bottom side, wherein the bottom side of the second conductive via is electrically coupled with the top side of the first conductive via, and wherein the second conductive via has a inwardly tapered walls extending from the bottom side of the second conductive via to the top side of the second conductive via.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as lowk dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

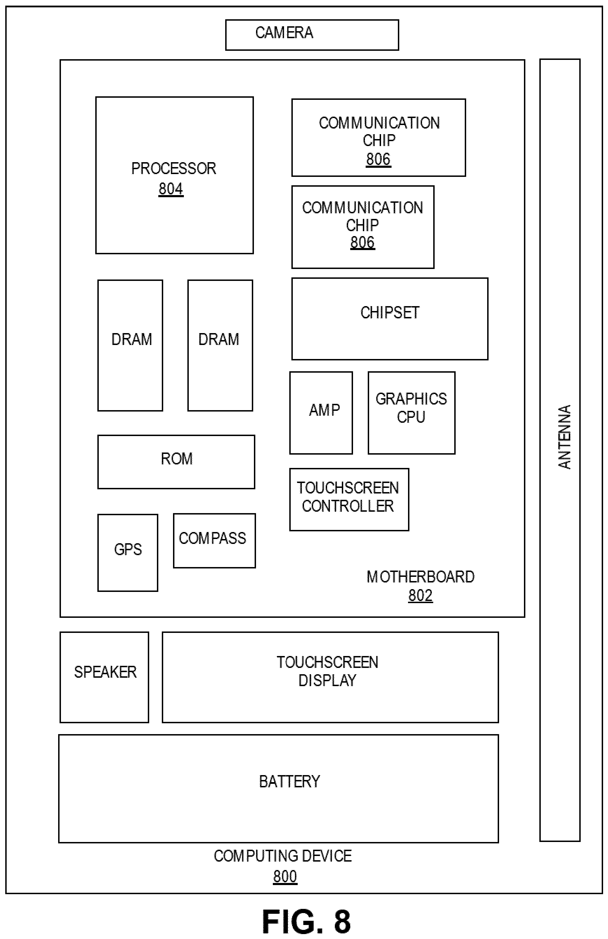

FIG. 8 illustrates a computing device 800 in accordance with one implementation of the invention. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the invention, the integrated circuit die of the communication chip includes one or more devices, such as MOS-FET transistors built in accordance with implementations of the invention.

In further implementations, another component housed within the computing device 800 may contain an integrated circuit die that includes one or more devices, such as MOS-FET transistors built in accordance with implementations of the invention.

In various implementations, the computing device 800 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

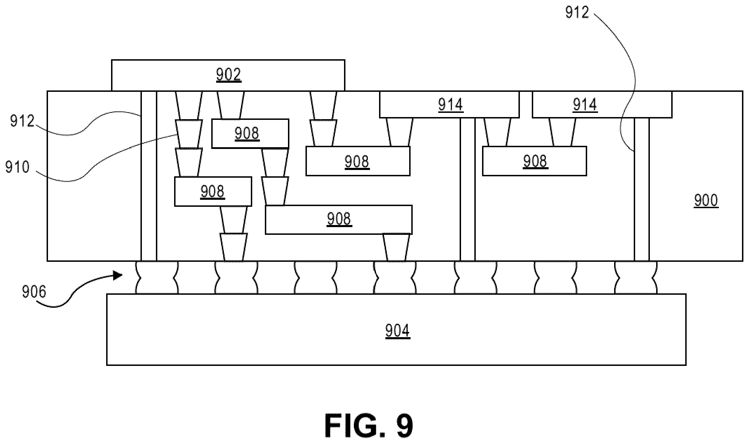

FIG. 9 illustrates an interposer 900 that includes one or more embodiments of the invention. The interposer 900 is an intervening substrate used to bridge a first substrate 902 to a second substrate 904. The first substrate 902 may be, for instance, an integrated circuit die. The second substrate 904 may be, for instance, a memory module, a computer motherboard, or another integrated circuit die. Generally, the purpose of an interposer 900 is to spread a connection to a wider pitch or to reroute a connection to a different connection. For example, an interposer 900 may couple an integrated circuit die to a ball grid array (BGA) 906 that can subsequently be coupled to the second substrate 904. In some embodiments, the first and second substrates 902/904 are attached to opposing sides of the interposer 900. In other embodiments, the first and second substrates 902/904 are attached to the same side of the interposer 900. And in further embodiments, three or more substrates are interconnected by way of the interposer 900.

The interposer 900 may be formed of an epoxy resin, a fiberglass-reinforced epoxy resin, a ceramic material, or a polymer material such as polyimide. In further implementations, the interposer 900 may be formed of alternate rigid or flexible materials that may include the same materials described above for use in a semiconductor substrate, such as silicon, germanium, and other group III-V and group IV materials.

The interposer 900 may include metal interconnects 908 and vias 910, including but not limited to through-silicon vias (TSVs) 912. The interposer 900 may further include embedded devices 914, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 900. In accordance with embodiments of the invention, apparatuses or processes disclosed herein may be used in the fabrication of interposer 900.

## Claims

1. An integrated circuit structure, comprising:
a gate structure (102) above a channel structure, the gate structure comprising a gate and a gate dielectric:
a first conductive via (115) having a bottom side and a top side opposite the bottom side,
the bottom side of the first conductive via electrically coupled with the gate,
the first conductive via having outwardly tapered walls extending from the bottom side of the first conductive via to the top side of the first conductive via;
a second conductive via (120) having a bottom side and a top side opposite the bottom side,
the bottom side of the second conductive via electrically coupled with the top side of the first conductive via,
the second conductive via having inwardly tapered walls from the bottom side of the second conductive via to the top side of the second conductive via.

2. The integrated circuit structure of claim 1, wherein the walls of the first conductive via have a slope between 90° and 85°, and wherein the walls of the second conductive via have a slope between 90° and 95°.

3. The integrated circuit structure of claim 1, further comprising a metallization layer (126) electrically coupled with the top side of the second conductive via.

4. The integrated circuit structure of claim 1, further comprising a barrier liner between the bottom side of the second conductive via and the top side of the first conductive via.

5. The integrated circuit structure of claim 1, wherein the bottom side of the first conductive via overlaps with a cut in the gate.

6. The integrated circuit structure of claim 1, 2, 3, 4 or 5, wherein the first metal via and the second metal via include copper.

7. A method, comprising:
forming a first layer of on top of a trench connector (107, 108) and a gate structure, with a first trench connector (107) at a first side of the gate structure and a second trench connector (108) at a second side of the gate structure opposite the first side of the gate structure, the gate structure including a gate (102) and a dielectric material,
wherein the first layer includes a first conductive via (115) having a bottom side and a top side opposite the bottom side,
wherein the bottom side is electrically coupled with the gate structure,
wherein the first conductive via has outwardly tapered walls extending from the bottom side of the first conductive via to the top side of the first conductive via; and
forming a second layer on top of the first layer,
wherein the second layer includes a second conductive via (120) having a bottom side and a top side opposite
the bottom side,
wherein the bottom side of the second conductive via is electrically coupled with the top side of the first conductive via,
wherein the second conductive via has a inwardly tapered walls extending from the bottom side of the second conductive via to the top side of the second conductive via.

8. The method of claim 7, wherein forming the first layer on top of the trench connector and the gate structure further includes forming a first pillar (560) on top of the first trench connector and forming a second pillar (562) on top of the second trench connector, the first pillar and the second pillar having, respectively, a bottom side and a top side opposite the bottom side, wherein the walls of the first pillar and the second pillar are inwardly tapered from the bottom side to the top side.

9. The method of claim 8, wherein forming the first layer on top of the trench connector and the gate structure further includes applying a spacer (566) to the walls of the first pillar and the second pillar.

10. The method of claim 9, wherein forming the first layer on top of the trench connector and the gate structure further includes:
applying a layer of pre-metal dielectric (PMD) (570) covering the first pillar and the second pillar; and
etching a volume of the PMD above the gate and between the first pillar and the second pillar, wherein the volume is bounded by a surface of the gate and the spacer covering the walls of the first pillar and the spacer covering the walls of the second pillar.

11. The method of claim 10, wherein forming the first layer on top of the trench connector and the gate structure further includes removing the first pillar and the second pillar.

12. The method of claim 11, wherein forming the first layer on top of the trench connector and the gate structure further includes depositing a metal layer (574) in contact with the surface of the gate, the top of the first trench connector, and the top of the second trench connector.

13. The method of claim 12, wherein forming the first layer on top of the trench connector and the gate structure further includes exposing the first trench connector, the second trench connector, and the first conductive via by planarizing the deposited metal layer.

14. The method of claim 7, 8, 9, 10, 11, 12 or 13, wherein forming the second layer on top of the first layer further includes forming the second conductive via on a top surface of the first conductive via.

15. The method of claim 14, wherein forming the second conductive via further includes performing a metal direct etch.

## Patentansprüche

1. Integrierte Schaltungsstruktur, die Folgendes umfasst:
eine Gate-Struktur (102) oberhalb einer Kanalstruktur, wobei die Gate-Struktur ein Gate und ein Gate-Dielektrikum umfasst;
eine erste leitende Durchkontaktierung (115) mit einer Unterseite und einer Oberseite gegenüber der Unterseite, wobei die Unterseite der ersten leitenden Durchkontaktierung elektrisch mit dem Gate gekoppelt ist, wobei die erste leitende Durchkontaktierung sich nach außen verjüngende Wände aufweist, die sich von der Unterseite der ersten leitenden Durchkontaktierung zur Oberseite der ersten leitenden Durchkontaktierung erstrecken;
eine zweite leitende Durchkontaktierung (120) mit einer Unterseite und einer Oberseite gegenüber der Unterseite, wobei die Unterseite der zweiten Durchkontaktierung elektrisch mit der Oberseite der ersten Durchkontaktierung gekoppelt ist,
wobei die zweite Durchkontaktierung von der Unterseite der zweiten Durchkontaktierung bis zur Oberseite der zweiten Durchkontaktierung sich nach innen verjüngende Wände aufweist.

2. Integrierte Schaltungsstruktur nach Anspruch 1, wobei die Wände der ersten Durchkontaktierung eine Neigung zwischen 90° und 85° aufweisen, und wobei die Wände der zweiten Durchkontaktierung eine Neigung zwischen 90° und 95° aufweisen.

3. Integrierte Schaltungsstruktur nach Anspruch 1, die ferner eine Metallisierungsschicht (126) umfasst, die elektrisch mit der Oberseite der zweiten Durchkontaktierung verbunden ist.

4. Integrierte Schaltungsstruktur nach Anspruch 1, die ferner eine Barriereschicht zwischen der Unterseite der zweiten Durchkontaktierung und der Oberseite der ersten Durchkontaktierung umfasst.

5. Integrierte Schaltungsstruktur nach Anspruch 1, wobei sich die Unterseite der ersten Durchkontaktierung mit einem Einschnitt im Gate überlappt.

6. Integrierte Schaltungsstruktur nach Anspruch 1, 2, 3, 4 oder 5, wobei die erste metallische Durchkontaktierung und die zweite metallische Durchkontaktierung Kupfer enthalten.

7. Verfahren, das Folgendes umfasst:
Bilden einer ersten Schicht auf einem Grabenverbinder (107, 108) und einer Gate-Struktur, mit einem ersten Grabenverbinder (107) an einer ersten Seite der Gate-Struktur und einem zweiten Grabenverbinder (108) an einer zweiten Seite der Gate-Struktur gegenüber der ersten Seite der Gate-Struktur, wobei die Gate-Struktur ein Gate (102) und ein dielektrisches Material enthält,
wobei die erste Schicht eine erste leitende Durchkontaktierung (115) mit einer Unterseite und einer der Unterseite gegenüberliegenden Oberseite aufweist,
wobei die Unterseite elektrisch mit der Gate-Struktur gekoppelt ist,
wobei die erste leitende Durchkontaktierung sich nach außen verjüngende Wände aufweist, die sich von der Unterseite der ersten leitenden Durchkontaktierung zur Oberseite der ersten leitenden Durchkontaktierung erstrecken; und
Bilden einer zweiten Schicht auf der ersten Schicht,
wobei die zweite Schicht eine zweite leitende Durchkontaktierung (120) mit einer Unterseite und einer der Unterseite gegenüberliegenden Oberseite aufweist,
wobei die Unterseite der zweiten leitenden Durchkontaktierung elektrisch mit der Oberseite der ersten leitenden Durchkontaktierung gekoppelt ist, wobei die zweite leitende Durchkontaktierung eine sich nach innen verjüngende Wand aufweist, die sich von der Unterseite der zweiten leitenden Durchkontaktierung zur Oberseite der zweiten leitenden Durchkontaktierung erstreckt.

8. Verfahren nach Anspruch 7, wobei das Bilden der ersten Schicht auf dem Grabenverbinder und der Gate-Struktur ferner das Bilden einer ersten Säule (560) auf dem ersten Grabenverbinder und das Bilden einer zweiten Säule (562) auf dem zweiten Grabenverbinder umfasst, wobei die erste Säule und die zweite Säule jeweils eine Unterseite und eine Oberseite gegenüber der Unterseite aufweisen, wobei die Wände der ersten Säule und der zweiten Säule von der Unterseite zur Oberseite nach innen verjüngt sind.

9. Verfahren nach Anspruch 8, wobei das Bilden der ersten Schicht auf dem Grabenverbinder und der Gate-Struktur ferner das Anbringen eines Abstandshalters (566) an den Wänden der ersten Säule und der zweiten Säule umfasst.

10. Verfahren nach Anspruch 9, wobei das Bilden der ersten Schicht auf dem Grabenverbinder und der Gate-Struktur ferner Folgendes umfasst:
Aufbringen einer Schicht eines Pre-Metall-Dielektrikums (PMD) (570), die die erste Säule und die zweite Säule bedeckt; und
Ätzen eines Volumens des PMD oberhalb des Gates und zwischen der ersten Säule und der zweiten Säule, wobei das Volumen durch eine Oberfläche des Gates und den Abstandshalter, der die Wände der ersten Säule bedeckt, und den Abstandshalter, der die Wände der zweiten Säule bedeckt, begrenzt ist.

11. Verfahren nach Anspruch 10, wobei das Bilden der ersten Schicht auf dem Grabenverbinder und der Gate-Struktur ferner das Entfernen der ersten Säule und der zweiten Säule umfasst.

12. Verfahren nach Anspruch 11, wobei das Bilden der ersten Schicht auf der Oberseite des Grabenverbinders und der Gate-Struktur ferner das Abscheiden einer Metallschicht (574) in Kontakt mit der Oberfläche des Gates, der Oberseite des ersten Grabenverbinders und der Oberseite des zweiten Grabenverbinders umfasst.

13. Verfahren nach Anspruch 12, wobei das Bilden der ersten Schicht auf dem Grabenverbinder und der Gate-Struktur ferner das Freilegen des ersten Grabenverbinders, des zweiten Grabenverbinders und der ersten leitenden Durchkontaktierung durch Planarisieren der abgeschiedenen Metallschicht umfasst.

14. Verfahren nach Anspruch 7, 8, 9, 10, 11, 12 oder 13, wobei das Bilden der zweiten Schicht auf der ersten Schicht ferner das Bilden der zweiten leitenden Durchkontaktierung auf einer oberen Oberfläche der ersten leitenden Durchkontaktierung umfasst.

15. Verfahren nach Anspruch 14, wobei das Bilden der zweiten leitenden Durchkontaktierung ferner das Durchführen einer direkten Metallätzung umfasst.

## Revendications

1. Structure de circuit intégré, comprenant :
une structure de grille (102) au-dessus d'une structure de canal, la structure de grille comprenant une grille et un diélectrique de grille ;
une première interconnexion verticale conductrice (115) ayant un côté inférieur et un côté supérieur opposé au côté inférieur,
le côté inférieur de la première interconnexion verticale conductrice étant couplé électriquement à la grille,
la première interconnexion verticale conductrice ayant des parois effilées vers l'extérieur s'étendant du côté inférieur de la première interconnexion verticale conductrice au côté supérieur de la première interconnexion verticale conductrice ;
une deuxième interconnexion verticale conductrice (120) ayant un côté inférieur et un côté supérieur opposé au côté inférieur,
le côté inférieur de la deuxième interconnexion verticale conductrice étant couplé électriquement au côté supérieur de la première interconnexion verticale conductrice,
la deuxième interconnexion verticale conductrice ayant des parois effilées vers l'intérieur depuis le côté inférieur de la deuxième interconnexion verticale conductrice jusqu'au côté supérieur de la deuxième interconnexion verticale conductrice.

2. Structure de circuit intégré selon la revendication 1, dans laquelle les parois de la première interconnexion verticale conductrice ont une pente comprise entre 90° et 85°, et dans laquelle les parois de la deuxième interconnexion verticale conductrice ont une pente comprise entre 90° et 95°.

3. Structure de circuit intégré selon la revendication 1, comprenant en outre une couche de métallisation (126) couplée électriquement au côté supérieur de la deuxième interconnexion verticale conductrice.

4. Structure de circuit intégré selon la revendication 1, comprenant en outre un revêtement barrière entre le côté inférieur de la deuxième interconnexion verticale conductrice et le côté supérieur de la première interconnexion verticale conductrice.

5. Structure de circuit intégré selon la revendication 1, dans laquelle le côté inférieur de la première interconnexion verticale conductrice chevauche une coupe dans la grille.

6. Structure de circuit intégré selon les revendications 1, 2, 3, 4 ou 5, dans laquelle la première interconnexion verticale métallique et la deuxième interconnexion verticale métallique comprennent du cuivre.

7. Procédé comprenant les étapes suivantes :
former une première couche sur le dessus d'un connecteur de tranchée (107, 108) et d'une structure de grille, avec un premier connecteur de tranchée (107) sur un premier côté de la structure de grille et un deuxième connecteur de tranchée (108) sur un deuxième côté de la structure de grille opposé au premier côté de la structure de grille, la structure de grille comprenant une grille (102) et un matériau diélectrique,
où la première couche comprend une première interconnexion verticale conductrice (115) ayant un côté inférieur et un côté supérieur opposé au côté inférieur, où le côté inférieur est couplé électriquement à la structure de grille,
où la première interconnexion verticale conductrice a des parois effilées vers l'extérieur s'étendant du côté inférieur de la première interconnexion verticale conductrice au côté supérieur de la première interconnexion verticale conductrice ; et
former une deuxième couche sur la première couche,
où la deuxième couche comprend une deuxième interconnexion verticale conductrice (120) ayant un côté inférieur et un côté supérieur opposé au côté inférieur, où le côté inférieur de la deuxième interconnexion verticale conductrice est couplé électriquement avec le côté supérieur de la première interconnexion verticale conductrice,
la deuxième interconnexion verticale conductrice présentant des parois effilées vers l'intérieur qui s'étendent du côté inférieur de la deuxième interconnexion verticale conductrice au côté supérieur de la deuxième interconnexion verticale conductrice.

8. Procédé selon la revendication 7, dans lequel la formation de la première couche sur le dessus du connecteur de tranchée et de la structure de grille comprend en outre la formation d'un premier pilier (560) sur le dessus du premier connecteur de tranchée et la formation d'un deuxième pilier (562) sur le dessus du deuxième connecteur de tranchée, le premier pilier et le deuxième pilier ayant, respectivement, un côté inférieur et un côté supérieur opposé au côté inférieur, où les parois du premier pilier et du deuxième pilier sont effilées vers l'intérieur depuis le côté inférieur jusqu'au côté supérieur.

9. Procédé selon la revendication 8, dans lequel la formation de la première couche sur le dessus du connecteur de tranchée et de la structure de grille comprend en outre l'application d'une entretoise (566) sur les parois du premier pilier et du deuxième pilier.

10. Procédé selon la revendication 9, dans lequel la formation de la première couche sur le dessus du connecteur de tranchée et de la structure de grille comprend en outre les étapes suivantes :
appliquer une couche de diélectrique prémétallique (PMD) (570) recouvrant le premier pilier et le deuxième pilier ; et
graver un volume de PMD au-dessus de la grille et entre le premier pilier et le deuxième pilier, le volume étant délimité par une surface de la grille et l'entretoise recouvrant les parois du premier pilier et l'entretoise recouvrant les parois du deuxième pilier.

11. Procédé selon la revendication 10, dans lequel la formation de la première couche sur le dessus du connecteur de tranchée et de la structure de grille comprend en outre le retrait du premier pilier et du deuxième pilier.

12. Procédé selon la revendication 11, dans lequel la formation de la première couche sur le dessus du connecteur de tranchée et de la structure de grille comprend en outre le dépôt d'une couche métallique (574) en contact avec la surface de la grille, le dessus du premier connecteur de tranchée, et le dessus du deuxième connecteur de tranchée.

13. Procédé selon la revendication 12, dans lequel la formation de la première couche sur le dessus du connecteur de tranchée et de la structure de grille comprend en outre l'exposition du premier connecteur de tranchée, du deuxième connecteur de tranchée et de la première interconnexion verticale conductrice par l'aplanissement de la couche métallique déposée.

14. Procédé selon les revendications 7, 8, 9, 10, 11, 12 ou 13, dans lequel la formation de la deuxième couche sur le dessus de la première couche comprend en outre la formation de la deuxième interconnexion verticale conductrice sur une surface supérieure de la première interconnexion verticale conductrice.

15. Procédé selon la revendication 14, dans lequel la formation de la deuxième interconnexion verticale conductrice comprend en outre la réalisation d'une gravure directe du métal.
